# EUROPÄISCHE PATENTANMELDUNG

(11) **EP 1 273 679 A1**
(43) Veröffentlichungstag der Anmeldung: **08.01.2003**
(21) Anmeldenummer: 02014780.7
(22) Anmeldetag: 04.07.2002
(51) Int. Cl.: C23C 28/00, C23C 16/40, C23C 14/08

(54) **Metallisches Bauteil mit äusserer Funktionsschicht und Verfahren zu seiner Herstellung**

(30) Priorität: 05.07.2001 DE 10132089
(71) Anmelder: CemeCon AG, 52146 Würselen (DE)
(72) Erfinder: Leyendecker, Antonius, Dr.-Ing., 52134 Herzogenrath (DE); Erkens, Georg, Dr.-Ing., 52068 Aachen (DE); Brodehl, Jörg, Dipl.-Ing., 52066 Aachen (DE); Pennings, Jürgen, Dipl.-Ing., 52066 Aachen (DE)
(74) Vertreter: Patentanwälte Wenzel & Kalkoff

(57) **Zusammenfassung**

Die Erfindung bezieht sich auf ein metallisches Bauteil, insbesondere ein Werkzeug, sowie auf ein Verfahren zu seiner Herstellung. Um ein Bauteil zu erhalten, das ein hohe Härte aufweist und über eine äußere Funktionsschicht verfügt, wird vorgeschlagen, auf ein Substrat 12 eine Hartstoffschicht 14 aufzubringen. Auf der Hartstoffschicht 14 wird eine poröse Aluminiumoxidschicht 16 erzeugt. Funktionsmaterialpartikel 18, beispielsweise Farbpigmente, Schmierstoffpartikel oder Duftstoffpartikel werden in Poren der Aluminiumoxidschicht eingelagert, um eine Funktionsschicht 16 zu erzeugen.

## Beschreibung

Die Erfindung bezieht sich auf ein metallisches Bauteil, insbesondere ein Werkzeug, mit einer äußeren Funktionsschicht sowie auf ein Verfahren zu seiner Herstellung.

Es ist bekannt, Bauteile, insbesondere Werkzeuge, mit einer Hartstoffschicht zu versehen. Eine solche Hartstoffschicht hat den Vorteil einer hohen Härte und kann so beispielsweise als Verschleißschutz dienen. Insbesondere für Werkzeuge zur Materialbearbeitung, beispielsweise zum Schneiden, Fräsen, Sägen, Bohren etc. ergeben sich durch Hartstoffbeschichtung erhebliche Vorteile. Als Hartstoffschichten sind verschiedene Materialien bekannt, beispielsweise Diamant, aber auch Titan-Nitrid oder Titan-Aluminium-Nitrid. Derartige Hartstoffschichten können beispielsweise mit bekannten PVD- oder CVD-Verfahren aufgebracht werden.

Zusätzlich sind allerdings auch häufig Funktionsschichten wünschenswert. Funktionsschichten auf Bauteilen, insbesondere auf Werkzeugen können verschiedenen Zwecken dienen. Bekannt sind bspw. Gleitschichten oder Farbschichten. Das Aufbringen derartiger Funktionsschichten auf Hartstoffschichten, insbesondere das Einfärben von Hartstoffschichten hat sich als problematisch erwiesen. Oft zeigt sich eine geringe Haftung der Funktionspartikel an der Hartstoffschicht.

Zur Herstellung einer Funktionsschicht zur Festschmierung ist es aus der DE-A-4038139 bekannt, in einer Gleitlagerschale auf einer Aluminium-Lagerlegierungsschicht durch Oxidation Aluminiumoxid mit offenen Poren zu erzeugen. Die offenen Poren werden dann mit einem Festschmiermittel gefüllt, so daß als Funktionsschicht eine Gleitschicht entsteht.

Eine andere Funktionsschicht ist eine Farbschicht, wie sie beispielsweise aus der EP-A-0535457 bekannt ist. Hier wird auf einem Aluminium-Körper eine Oxidschicht gebildet, deren Poren mit einem Pigment gefüllt werden.

In der EP-A-0414025 ist das Aufbringen einer Aluminium-Schicht auf einen Körper beschrieben. Dies kann galvanisch oder durch ein PVD-Verfahren (Physical Vapor Deposition) erfolgen. Die gebildete Schicht wird anodisch oxidiert, um eine Al₂O₃-Schicht zu erzeugen, die als oberflächliche Schutzschicht dient.

Der Erfindung liegt die Aufgabe zugrunde, ein Bauteil sowie ein Verfahren zur Herstellung eines Bauteils anzugeben, wobei auf dem Bauteil, das eine hohe Härte aufweisen soll, zusätzlich eine Funktionsschicht vorhanden ist.

Die Aufgabe wir gelöst durch ein Verfahren nach Anspruch 1 und ein Bauteil nach Anspruch 10. Abhängige Ansprüche beziehen sich auf vorteilhafte Ausführungsformen der Erfindung.

Erfindungsgemäß wird ein Herstellungsverfahren vorgeschlagen mit den folgenden Schritten:
a) Aufbringen einer Hartstoffschicht auf die Oberfläche eines Bauteil-Substrats
b) Erzeugen einer porösen Aluminiumoxidschicht auf der Hartstoffschicht und
c) Einlagern von Funktionsmaterialpartikeln in Poren der Aluminiumoxidschicht zur Erzeugung einer Funktionsschicht.

Die Hartstoffschicht kann aus gängigen Hartstoffmaterialien oder Kombinationen davon gebildet sein. Es sind Mono-, Multi- und Nanolayer-Strukturen möglich. Besonders hervorzuheben sind Kombinationen von Titan mit sämtlichen möglichen Metallen sowie metallische Oxide. Das aufgebrachte Hartstoffmaterial ist bevorzugt aus der Gruppe ausgewählt, die TiN, TiAlN, TiZrN, TiCN, CrN, MoS_{2,} ZrO₂, TiOₓ und Al₂O₃ umfaßt. Diese sämtlichen Materialien für die Hartstoffschicht sind dazu geeignet, daß auf sie in Schritt b) eine Aluminiumoxidschicht aufgebracht wird. Auch andere Hartstoffmaterialien sind möglich, soweit gewährleistet ist, daß eine Aluminium- oder Aluminiumoxidschicht an ihnen anhaftet.

Für das Aufbringen der Hartstoffschicht können sämtliche hierfür bekannten Verfahren eingesetzt werden. Es ist jedoch bevorzugt, daß die Hartstoffschicht mit einem Verfahren aufgebracht wird, das aus der Gruppe ausgewählt ist, die PVD-, CVD-, PACVD- und Arcverfahren umfaßt.

Die erfindungsgemäße Funktionsschicht ist gebildet als poröse Aluminiumoxidschicht, die als Trägerschicht für verschiedene Funktionsmaterialpartikel dient. Als besondere Anwendungsgebiete werden angesehen das Einfärben der Aluminiumoxidschicht durch Einlagerung von Farbpigmenten in die Poren der Aluminiumoxidschicht, die Einlagerung von Duftstoffpartikeln in die Poren und die Einlagerung von Schmiermittelpartikeln in die Poren. Die poröse Struktur von Aluminiumoxid gewährleistet eine gute Haftung der Funktionspartikel auf der Harstoffschicht.

Im Falle der Einlagerung von Farbpigmenten wird eine äußere Funktionsschicht gebildet, die eine Unterscheidung verschiedener Bauteile gleicher Art anhand der Farbe ermöglicht. Sofern in die Poren der Aluminiumoxidschicht Duftstoffe eingelagert werden, kann beispielsweise mit Hilfe einer sogenannten elektronischen Nase ein Standzeitende des Werkzeugs ermittelt werden, denn ein Fehlen der Duftstoffe ist gleichbedeutend mit dem kommenden Ende der Standzeit des Werkzeugs.

Die Funktionsschicht kann auch zu Schmierzwecken eingesetzt werden. In diesem Falle können beispielsweise Kohlenstoffpartikel, Partikel aus Molybdänsulfit, Wolframsulfit, PTFE, Bornitrid oder Boroxid in die Poren (Kanäle) der Aluminiumoxidschicht eingebracht werden. Dies erfolgt beispielsweise mit Hilfe von Elektroden in einer Elektrolytlösung, wobei entweder die Elektroden aus passendem Material hergestellt sind oder die einzulagernden Materialpartikel für die Funktionsschicht in Lösung vorliegen.

Unabhängig von Ihrer Art sollten die Partikel in einem Größenbereich von 0,001 bis 0,1 µm liegen, bevorzugt jedoch in dem Bereich von 0,01 bis 0,04 µm.

In Schritt b) kann entweder direkt eine Aluminiumoxidschicht auf die Hartstoffschicht aufgebracht werden oder aber es wird zunächst eine Aluminiumschicht auf die Hartstoffschicht aufgebracht, die anschließend in eine Aluminiumoxidschicht umgewandelt wird, wie dies durch anodische Oxidation möglich ist. Die Verfahrensschritte des anodischen Oxidierens einer Aluminiumschicht und des Einbringens von Funktionspartikeln, bspw. Einfärbens der Aluminiumoxidschicht können auch zeitgleich durchgeführt werden, sofern eine geeignete Elektrolytlösung verwendet wird.

Die Aluminium oder Aluminiumoxidschicht wird bevorzugt in einem PVD-Verfahren auf die Hartstoffschicht aufgedampft, wobei als spezielle Verfahrensvariante eines PVD-Beschichtungsverfahrens ein Puls-PVD-Verfahren hervorzuheben ist. Hierbei werden die mit Targets bestückten Elektroden einer PVD-Beschichtungsanlage mit (bevorzugt pulsförmiger) Wechselspannung so beaufschlagt, daß sie wechselweise Anode und Kathode sind. Mit einem Puls-PVD-Verfahren können nichtleitende Stoffe wie Aluminiumoxid im PVD-Verfahren abgeschieden werden. Die Frequenz der verwendeten Wechselspannung kann im Bereich von 10 bis 200 kHz liegen. Auch eine hochfrequente Wechselspannung mit einer Frequenz von 10 bis 20 MHz ist möglich. Bevorzugt wird unipolar oder bipolar gearbeitet.

Die am Ende der Durchführung des Verfahrensschritts b) vorhandene Aluminiumoxidschicht weist eine poröse Oberfläche auf, die dafür genutzt werden kann, eine Einfärbung vorzunehmen bzw. andere Funktionspartikel einzulagern.

Die Schritte des erfindungesgemäßen Verfahrens müssen nicht zwingend zeitlich direkt aufeinanderfolgend ausgeführt werden. Zwischen den Schritten können weitere Maßnahmen, beispielsweise Vor- oder Nachbehandlungen durchgeführt werden. Besonders vorteilhaft ist es jedoch, die Schritte a) und b), d.h. das Aufbringen einer Hartstoffschicht und das Aufbringen einer Schicht aus Aluminium oder Aluminiumoxid zeitlich direkt aufeinanderfolgend innerhalb derselben PVD-Beschichtungsanlage durchzuführen, bevorzugt ohne Vakuum-Unterbrechung.

Es ist hervorzuheben, daß im Zusammenhang mit der Beschreibung der Erfindung und in den Ansprüchen der Begriff "Einfärben" sowohl im Sinne eines vollständigen als auch eines partiellen Einfärbens eines Bauteils zu verstehen ist.

Bei dem erfindungsgemäßen Bauteil, bei dem es sich insbesondere um ein Werkzeug handeln kann, ist auf einem Substrat eine Hartstoffschicht und auf der Hartstoffschicht eine Funktionsschicht vorhanden. Die Funktionsschicht umfaßt eine poröse Aluminiumoxidschicht, in deren Poren Funktionsmaterialpartikel eingelagert sind. Ein solches Bauteil kann nach dem oben beschriebenen Verfahren hergestellt werden.

Die Aluminiumoxidschicht hat bevorzugt eine Dicke im Bereich zwischen 0,1 und 20 µm, besonders bevorzugt zwischen 3 und 5 µm. Letztgenanntes Intervall für die Schichtdicke der Aluminiumoxidschicht ist ein günstiger Kompromiß zwischen einer Mindestschichtdicke, die für die Einlagerung von Funktionspartikel, beispielsweise Farbpigmenten in Poren der Aluminiumoxidschicht erforderlich ist, und der Menge an Aluminium bzw. Aluminiumoxid, die auf die Hartstoffschicht aufzubringen ist, so daß eine nachträgliche Einfärbung ermöglicht wird. Bevorzugt sollte die Schichtdicke der Aluminiumoxidschicht wenigstens 3 µm betragen. Eine Obergrenze für die Aluminiumoxidschichtdicke wird bestimmt durch den Effekt, daß bei sehr hohen Schichtdicken ein Verschleiß ausgesetztes Bauteil im Einsatz einem Verschmieren der Aluminiumoxidschicht unterliegt. Abhängig vom Anwendungsfall des Bauteils ist dieser Effekt in ausreichendem Maße zu vermeiden.

Während grundsätzlich sämtliche Farbstoffe zum Einfärben der Aluminiumoxidschicht geeignet sind, die mit dieser Schicht ein ausreichendes Haftvermögen aufweisen, ist es bevorzugt, daß in den Poren an der äußeren Oberfläche der Aluminiumoxidschicht Farbpigmente eingelagert sind.

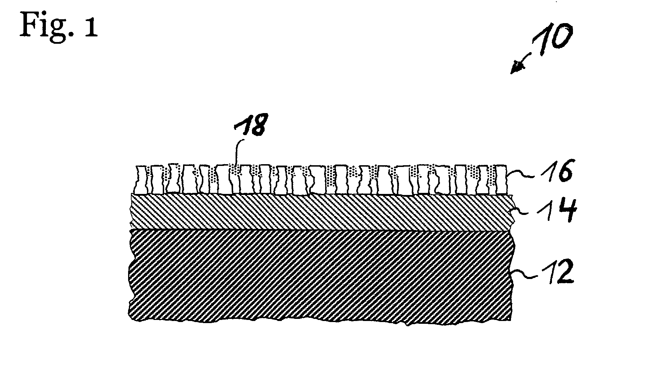

Die Erfindung wird nachfolgend anhand von Ausführungsbeispielen noch näher erläutert. Hierbei zeigt
Fig. 1 eine schematische Darstellung eines Querschnitts durch ein Ausführungsbeispiel eines erfindungsgemäßen Körpers.

Fig. 1 zeigt einen Teil eines Körpers 10, der aus einem Substrat 12, einer auf das Substrat aufgebrachten Hartstoffschicht 14 und einer äußeren Funktionsschicht 16 besteht. Die Darstellung ist hierbei lediglich schematisch und nicht maßstabsgetreu.

Die Funktionsschicht 16 besteht aus porösem Aluminiumoxid, das eine Anzahl von Kanälen aufweist. In den Kanälen an der Oberfläche der Schicht 16 sind Funktionspartikel 18 eingelagert.

Nachfolgend werden zwei Beispiele für die Herstellung derartiger Körper erläutert.

### Beispiel 1

Auf einen HSS-Bohrer mit einem Durchmesser von 8 mm wird zunächst eine Hartstoffschicht aufgebracht. Hierzu wird der Bohrer in einem CVD-Verfahren mit einer kristallinen Diamant-Schicht beschichtet. Das Vorgehen bei der CVD-Beschichtung mit Diamant ist dem Fachmann als solches bekannt.

Soweit erforderlich, wird der HSS-Bohrer einer Vorbehandlung zum Entfetten mittels NaOH (25 %-ig) unterzogen.

Der HSS-Bohrer wird in eine PVD-Beschichtungsanlage eingebracht. Mittels PVD-Zerstäubung von Al-Targets wird der Bohrer mit einer 3 µm dicken Aluminiumschicht versehen, die auf die Hartstoffschicht aufgebracht wird. Anschließend wird das aufgetragene Aluminium anodisch oxidiert. Dabei wird der HSS-Bohrer mit einer Anode elektrisch leitend verbunden, beispielsweise dem Pluspol einer Gleichstromquelle (220 V/1,5 A), und in eine Elektrolytlösung aus 750 ml Wasser und 250 ml Schwefelsäure (ρ = 1,84 g/gm³) und 25 g Aluminiumsulfat eingetaucht.

Aluminiumhaltige Kathoden, die mit dem Minuspol der Gleichstromquelle elektrisch leitend verbunden sind, werden ebenfalls in die Elektrolytlösung eingetaucht.

Nunmehr beginnt die anodische Oxidation, wobei für 20 Minuten ein Strom von ca. 0,15 A angelegt wird.

Nach Ablauf der anodischen Oxidation wird der Bohrer zu Spülzwecken kurz in Wasser getaucht. Nunmehr liegt die zum Einfärben vorgesehene Aluminiumoxidschicht an der Außenseite des Bohrers vor.

Zum Einfärben wird der Bohrer für die Zeit von einer halben Stunde in eine Farblösung aus Methylenblau (Methyltioniniumchlorid) getaucht, wobei sich die Poren der Aluminiumoxidschicht mit der Farblösung vollsaugen, sich insbesondere Farbpigmente in die Poren der Aluminiumoxidschicht einlagern.

Zum Fixieren der Farbschicht aus Methylenblau wird der Bohrer nun noch für 30 Minuten in ein Bad mit kochendem Wasser gehängt.

Nach Abschluß des Verfahrens ist das Verfahrensprodukt ein mit blauer Farbe überzogener, diamantbeschichteter HSS-Bohrer.

### Beispiel 2

In einer PVD-Beschichtungsanlage wird ein 12 mm-HSS-Fräser zunächst mit einer Hartstoffschicht beschichtet. Hierfür werden im Vakuum Targets zerstäubt, indem sie mit Ar+-Ionen beschossen werden, die durch eine Gleichspannung in Richtung der Targets beschleunigt werden. Die Elektroden sind hierbei mit Targets in Form von Al-Platten bestückt, in die Ti-Stopfen eingesetzt sind. Auf dem Fräser wird so eine Hartstoffschicht in Form einer 3µm dicken Ti-Al-N-Schicht aufgebracht.

Anschließend wird in derselben PVD-Beschichtungsanlage, ohne Vakuumunterbrechung, Aluminiumoxid in einem Pulsverfahren aufgebracht, d.h. unter Beaufschlagung von Al-Targets mit einer Wechselspannung so, daß sie abwechselnd Anode und Kathode bilden. Unter Zuleitung von Sauerstoff als reaktivem Gas wird so direkt eine 3 µm dicke Aluminiumoxidschicht auf der Hartstoffschicht gebildet. Im Gegensatz zu Beispiel 1 entfällt der Schritt der anodischen Oxidierung.

Die sich ergebende Aluminiumoxidschicht kann mittels des Farbstoffes solvent green 3 eingefärbt werden. Zu diesem Zweck wird der Farbstoff solvent green 3 in Wasser gelöst. In diese Lösung wird der Fräser für 30 Minuten eingetaucht. Im Anschluß daran erfolgt die Fixierung der Farbe durch Eintauchen des Fräsers in ein Bad kochenden Wassers.

Im Ergebnis hat der Fräser eine grüne Farbe als Überzug angenommen.

Die genannten Beispiele sind so zu verstehen, daß sie jeweils eine Möglichkeit der Kombination alternativer Arbeitsschritte angeben. Die verschiedenen Verfahren zur Hartstoffbeschichtung, die Verfahren zur Erzeugung einer Aluminiumoxidschicht und zur Einlagerung von Funktionspartikeln können vom Fachmann für einen bestimmten Anwendungsfall auch in anderer Weise kombiniert werden.

## Patentansprüche

**1.** Verfahren zum Herstellen eines Bauteils, insbesondere eines Werkzeugs, mit den Schritten:
a) Aufbringen einer Hartstoffschicht (14) auf die Oberfläche eines Bauteil-Substrats (12)
b) Erzeugen einer porösen Aluminiumoxidschicht (16) auf der Hartstoffschicht (14) und
c) Einlagern von Funktionsmaterialpartikeln (18) in Poren der Aluminiumoxidschicht (16) zur Erzeugung einer Funktionsschicht (16)

**2.** Verfahren nach Anspruch 1, bei dem in Schritt c) Farbpigmente in die Poren an der äußeren Oberfläche der Aluminiumoxidschicht (16) eingelagert werden.

**3.** Verfahren nach Anspruch 1, bei dem in Schritt c) Schmierstoffpartikel in die Poren an der äußeren Oberfläche der Aluminiumoxidschicht (16) eingelagert werden.

**4.** Verfahren nach Anspruch 1, bei dem in Schritt c) Duftstoffpartikel in die Poren der äußeren Oberfläche der Aluminiumoxidschicht (16) eingelagert werden.

**6.** Verfahren nach einem der vorangehenden Ansprüche, bei dem in Schritt a) die Hartstoffschicht (14) mit einem Verfahren aufgebracht wird, das aus der Gruppe ausgewählt ist, die PVD-, CVD-, PACVD- und Arcverfahren umfaßt.

**7.** Verfahren nach einem der vorangehenden Ansprüche, bei dem
- in Schritt b) Aluminium durch PVD-Zerstäubung auf die Hartstoffschicht (14) aufgebracht
- und anschließend durch anodische Oxidation in Aluminiumoxid umgewandelt wird.

**8.** Verfahren nach einem der Ansprüche 1-6, bei dem
- in Schritt b) Aluminiumoxid durch ein PVD-Puls-Zerstäubungsverfahren auf die Hartstoffschicht (14) aufgebracht wird.

**9.** Verfahren nach einem der Ansprüche 1 - 6, bei dem in Schritt b) Aluminium oder Aluminiumoxid mittels CVD- oder PACVD-Beschichtung aufgebracht wird.

**10.** Bauteil, insbesondere Werkzeug, bestehend aus
- einem Substrat (12)
- einer auf dem Substrat aufgebrachten Hartstoffschicht (14),
- und einer auf der Hartstoffschicht (14) aufgebrachten Funktionsschicht (16), die poröses Aluminiumoxid umfaßt, wobei in Poren des Aluminiumoxids Funktionsmaterialpartikel (18) eingelagert sind.

**11.** Bauteil nach Anspruch 10, bei dem mindestens in Poren an der Oberfläche der Aluminiumoxidschicht (16) Farbpigmente, Schmiermittelpartikel oder Duftstoffpartikel eingelagert sind.

**12.** Bauteil nach einem der Ansprüche 10 oder 11, bei dem die Aluminiumoxidschicht eine Dicke im Bereich zwischen 0,1 und 20 µm hat.
